# EUROPÄISCHE PATENTSCHRIFT

(11) **EP 2 562 879 B1**
(45) Veröffentlichungstag und Bekanntmachung des Hinweises auf die Patenterteilung: **24.10.2018**
(21) Anmeldenummer: 12181609.4
(22) Anmeldetag: 23.08.2012
(51) Int. Cl.: H05K 7/14, H01R 9/26, H01R 13/11

(54) **Querrangierung unterstützendes E/A-Modul und elektrisches Kontaktelement**
I/O module supporting transverse routing and electrical contact element
Module d'entrées-sorties assisté d'un câblage transversal et élément de contact électrique

(30) Priorität: 24.08.2011 DE 102011052964
(43) Veröffentlichungstag der Anmeldung: 27.02.2013
(73) Patentinhaber: PHOENIX CONTACT GmbH & Co. KG, 32825 Blomberg (DE)
(72) Erfinder: Johannes, Matthias, 31812 Bad Pyrmont-Thal (DE)
(74) Vertreter: Michalski Hüttermann & Partner Patentanwälte mbB

(56) Entgegenhaltungen:
- EP-A2- 0 951 102
- DE-C1- 19 718 996
- DE-U1-202010 006 065
- US-A1- 2007 275 586

## Beschreibung

Die Erfindung betrifft eine E/A-Modul zur Montage auf einer Hutschiene, wobei das E/A-Modul seitlich neben einem anderen E/A-Modul seiner Art auf einer Hutschiene montierbar ist und mit dem anderen E/A-Modul seitlich zur Erzielung einer Querrangierung über einen Messer/Gabelkontakt kontaktierbar ist. Die Erfindung betrifft ferner ein elektrisches Kontaktelement, welches als kombiniertes Messer-Gabel-Kontaktelement ausgebildet ist, zur Erzielung einer Querrangierung zwischen E/A-Modulen.

Die Erfindung betrifft damit allgemein die Automatisierungstechnik. In der Automatisierungstechnik werden für den Aufbau von Steuerungsanlagen von verschiedenen Herstellen jeweils unterschiedlichste E/A-Module angeboten, aus welchen, einem Baukastensystem gleich, für die jeweils zu erfüllende Steuerungsaufgabe unterschiedliche Komponenten ausgewählt und miteinander kombiniert werden können. Der Aufbau entsprechender Steuerungen erfolgt in Schaltschränken, innerhalb derer die E/A-Module zumeist nebeneiander auf quer verlaufenden Schienen angeordnet werden. Dabei bieten die quer verlaufenden und normierten, auch Hutschienen genannten Schienen lediglich eine mechanische Befestigungsfunktion. Die elektrische Verknüpfung der E/A-Module untereinander erfolgt durch individuelle Einzelverdrahtung oder aber auch durch BUS-Systeme, wie aus der DE 44 02 002 B4 bekannt.

Die Erstellung der individuellen Einzelverdrahtung stellt eine zeitintensive und fehleranfällige Aufgabe dar, sie erfolgt manuell und kostenintensiv durch einen Elektroinstallateur.

Um den Installationsaufwand zu verringern sind aus dem Stand der Technik mehrere Ansätze bekannt, um Spannungsversorgung oder von mehreren E/A-Modulen gleichermaßen benötigte Signalleitungen im Sinne eines Bus-Systems oder einer Querrangierung untereinander, durch entsprechende Kontaktierungssysteme von E/A-Modul zu E/A-Modul weiterzuleiten.

In der DE 44 02 002 B4 wird ein E/A-Modul beschrieben, welches über Seitenwandkontakte in den Seitenflächen eine elektrische Querverbindung mit den direkt benachbarten Modulen herstellen kann. Die seitlichen Kontakte sind dabei als Druckkontakte ausgeführt, welche jederzeit das Bestreben aufweisen, die Module seitlich auseinanderzudrücken. Dem wird entgegnet, indem eine Gruppe untereinander kontaktierter Module mittels auf der Tragschiene montierter Endwinkel zusammengehalten wird, oder alternativ dadurch, dass die einzelnen Module an ihren Seitenflächen korrespondierende hakenförmige Vor- und Rücksprünge aufweisen, die bei der Montage der Module ineinander greifen und auf diese Weise mechanisch ein Auseinanderrücken verhindern.

Die DE 20 2010 006 065 U1 beschreibt ein E/A-Modul, bei welchem eine Querkontaktierung über einen Gabelkontakt erfolgt. Die Unterseite des Modulgehäuses weist dazu eine Nut auf, welche das Einführen eines Messerkontaktes eines benachbarten E/A-Modules erlaubt, so dass das Einführen des Messerkontaktes des Nachbarmoduls von unten durch die Nut in den Gabelkontakt des E/A-Moduls ermöglicht wird. Dabei wird der Gabelkontakt in Montagerichtung (Richtung der Normalen der Hutschiene) durch seitliches Ineinanderschieben der E/A-Module geschlossen, so dass die Anordnung im wesentlichen frei ist von Querkräften in der Achse entlang der Hutschiene. An den Busklemmen sind korrespondierende Vor- und Rücksprünge ausgebildet, um ein Einführen benachbarter Busklemmen zu ermöglichen.

Im Vergleich zur DE 44 02 002 B4 treten bei der DE 20 2010 006 065 U1 also keine oder zumindest deutlich geringere das Modulpaket auseinanderdrückenden Federkräfte auf. Dafür aber ist es nicht möglich, aus einer auf der Hutschiene montierten Modulgruppe ein einzelnes Modul herauszulösen. Vielmehr erfordert das in der DE 20 2010 006 065 U1 beschriebene Modul eine Gruppierung der Module vor der Montage auf der Hutschiene bzw. eine Demontage der gesamten Gruppe, um ein einzelnes zu ersetzen.

Aus der DE 197 18 996 C1 ist ein elektrisches oder elektronisches Gerät zum Aufsetzen auf eine Tragschiene bekannt. Das Gerät umfasst ein Gehäuse, wenigstens eine im Gehäuse angeordneten Leiterplatte und wenigstens ein Kontaktmittel einerseits zur Kontaktierung mit der Leiterplatte, andererseits für eine Daten- und/oder Energiebusverbindung mit benachbarten, auf die Tragschiene aufgesetzten und korrespondierende Kontaktmittel aufweisenden Geräten. Das Kontaktmittel weist einen Leiterplattenkontakt, einen vorderen Buskontakt und einen hinteren Buskontakt auf. Der vordere Buskontakt ist dabei als Messerkontakt ausgeführt, und der hintere Buskontakt als Gabelkontakt. Der Gabelkontakt ist derart geformt, dass er sich jeweils von oben und unten zur Mitte verjüngt. Weiter ist aus der EP 0 951 102 A2 ein Leistungsverbinder bekannt, der eine Mehrzahl Gabelkontakte aufweisen kann.

Aus der US 2007/0275586 A1 ist ein Verbindersystem bekannt. Die dortigen Verbinder umfassen jeweils eine Gabel, bei der eine Klaue als Messerkontakt ausgeführt ist.

Der Erfindung liegt die Aufgabe zu Grunde, ein E/A-Modul anzugeben, welches sowohl frei von Querkräften gruppiert werden kann und welches zudem einen Austausch einzelner E/A-Module einer Gruppe ermöglicht, ohne dass die gesamte Gruppe demontiert werden müsste. Eine weitere Aufgabe der Erfindung ist es, ein elektrisches Kontaktelement anzugeben, welches zur Erzielung einer Querrangierung zwischen E/A-Modulen geeignet ist.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist damit vorgesehen ein elektrisches E/A-Modul zur Montage auf einer Hutschiene, wobei das E/A-Modul seitlich neben einem anderen E/A-Modul seiner Art auf einer Hutschiene montierbar ist und mit dem anderen E/A-Modul seitlich zur Erzielung einer Querrangierung über einen Messer/Gabelkontakt kontaktierbar ist, an den E/A-Modulen Kontaktelemente zur Herstellung des Messer/Gabelkontakts angeordnet sind, die Kontaktelemente als kombiniertes Messer-Gabel-Kontaktelement ausgeführt sind, wobei das kombinierte Messer-Gabel-Kontaktelement ein wenigstens zwei Klauen umfassendes Gabelkontaktelement aufweist, wobei wenigstens eine der Klauen geradlinig als Messerkontaktelement ausgebildet ist, das
Messerkontaktelement flächig ausgebildet und seitlich angefast ist, eine seitlich offene Ausgestaltung der Kontaktelemente ein Öffnen und Schließen des Messer-Gabel-Kontakts in verschiedenen Richtungen der Ebene des Messerkontaktelements ermöglicht, so dass der Messer/Gabelkontakt durch Bewegung des E/A-Moduls sowohl in der Achse der Normalen der Hutschiene als auch in der Längsachse der Hutschiene zu öffnen bzw. zu schließen ist.

Mit anderen Worten wird eine Lösung vorgeschlagen, bei der einzelne E/A-Module durch Messer/Gabel-Kontakte untereinander elektrisch querverbindbar sind, wobei es nicht erforderlich ist, die Module vor der Montage auf der Hutschiene zu gruppieren, sondern bei der ein weiteres zu montierendes Modul sowohl von oben neben ein bereits montiertes Modul auf die Hutschiene aufgeklipst werden kann, als auch durch seitliches Verschieben auf der Hutschiene mit diesem kontaktiert werden kann.

Für den umgekehrten Vorgang, bei der Demontage oder dem Austausch eines Moduls, bedeutet dies, dass nicht die gesamte Gruppe von der Hutschiene entfernt werden muss, sondern dass durch Verschieben des Moduls auf der Hutscheine Messer- und Gabelkontaktelement voneinander getrennt werden können und auf diese Weise ein einzelnes Modul von der Schiene entfernt werden kann.

Damit weist die Erfindung sowohl den Vorteil der Zugänglichkeit einzelner Module als auch den Vorteil einer in Querrichtung mechanisch spannungsfreien Anordnung auf.

Vorzugsweise ist das E/A-Modul wechselseitig mit einem Messer- bzw. einem Gabelkontaktelement versehen, also auf einer Seite mit einem Messerkontakt und auf der anderen Seite mit einem Gabelkontakt, so dass mehrere Module dieser Art ohne weitere Kontaktierungsaufwände mit einer Spannungsversorgung
oder Signalleitungen sequentiell aneinandergereiht werden können.

Ebenfalls vorteilhaft ist wenigstens eines der Kontaktelemente des Messer-Gabelkontakts innerhalb der Grundfläche des Moduls angeordnet, d.h. wenigstens ein Kontaktelement des Messer-Gabelkontakts ist so angeordnet, dass die äußeren Abmessungen, insbesondere die Einbaubreite des Moduls nicht durch herausragende Kontaktelemente vergrößert ist.

Desweiteren vorteilhaft liegt das wenigstens eine Kontaktelement des Messer/Gabel-Kontakts geschützt innerhalb des Gehäuses des E/A-Moduls und ist durch eine Gehäuseöffnung hindurch zugänglich.

Ebenfalls vorteilhaft ist das Kontaktelement an einer Kante des Moduls angeordnet, so dass es von beiden die Kante ausprägenden Flächen her zugänglich ist. So kann das Gabelkontaktelement beispielsweise so an der unteren rechten Gehäusekante angeordnet sein, dass er für ein entsprechendes Messerkontaktelement sowohl von unten als auch von rechts her zugänglich ist.

Dabei bietet ein an einer unteren Kante z.B. durch eine Gehäusenut zugänglicher angeordneter Gabelkontakt den Vorteil, dass der Gabelkontakt bei sukzessiver Montage der Module auf ein aus einem Nachbarmodul herausragenden Messerkontakt aufgedrückt werden kann, oder mit anderen Worten, über den Messerkontakt gestülpt wird.

In gleicher Weise ist auch eine Ausgestaltung mit einem Gabelkontakt an der beispielsweise oberen rechten Gehäusekante möglich, wobei ein Messerkontakt eines rechts neben dem E/A-Modul montierten Nachbarmodul von oben oder von der Seite in den Gabelkontakt eingeführt werden kann.

Gleichwohl kann das Gehäuse aber auch eine seitliche Ausnehmung aufweisen, die es ermöglicht einen Messerkontakt zunächst von der Seite her einzuführen, um ihn dann in einer anderen Richtung in den Gabelkontakt hineinzudrücken.

Ebenso kann der Messerkontakt in der Grundfläche des E/A-Modules angeordnet sein und in analoger Weise wie zuvor beschrieben mit einem aus dem Nachbarmodul herausragenden Gabelkontakt interagieren.

In einer weiteren vorteilhaften Ausgestaltung der Erfindung ist der Messer- bzw. Gabelkontakt von drei Seiten des Modules her zugänglich, von oben, von unten und von einer Seite. Der Vorteil einer solchen Ausgestaltung liegt darin, dass zur nachträglichen Montage oder einer Demontage eines E/A-Moduls, z.B. aus einer sich zu beiden Seiten fortsetzenden Gruppe von E/A-Modulen, in einen gerade hinreichend breiten Slot im Schaltschrank kein Verschieben anderer Module erforderlich ist, da der in den eigenen Slot hineinragende Messer- oder Gabelkontakt des Nachbarmoduls von bzw. nach hinten ein bzw. ausgeführt werden kann. Ebenso kann der eigene, in einen Nachbarslot hineinragende Messer- oder Gabelkontakt im gleicher Weisen ausgeführten E/A-Modul dort nach oben ausgeführt (Demontage) oder von oben eingeführt (Montage) werden.

Für den Fall, dass die Kontakte im Inneren des Gehäuses angeordnet sind, ermöglicht eine sich vorzugsweise über eine Seitenfläche ziehende, sowohl von oben als auch von unten zugängliche Nut das Einführen der Kontakte.

In einer weiteren Ausgestaltung können die E/A-Module beidseitig mit innen liegenden Gabelkontakten ausgebildet sein. Diese Ausführung besitzt den Vorteil, dass keine Kontakte in die Slots der Nachbarmodule ragen. Dies ist dann von Vorteil, wenn sehr wenig Raum zur Verfügung steht oder am Ende eine Gruppe keine Kontakte aus dem äußersten E/A-Modul herausragen dürfen.

Dabei können beidseitig mit Gabelkontakten ausgestattete E/A-Module auf einfache Weise mit doppelseitigen Messerkontakten untereinander kontaktiert werden.

In einer vorteilhaften Ausgestaltung werden Messer- und/oder Gabelkontakt als Stanzbiegeelement ausgeführt. Dabei können die Stanzbiegeelemente in eine U-förmige Form gebracht werden, wobei die beiden Schenkel des "U" gegeneinander federnd einen Gabelkontakt ausbilden. Desweiteren werden Messerkontaktelement wie auch Gabelkontaktelement vorzugsweise symmetrisch ausgebildet, welches zum einen zum Vorteil hat, dass für beide Kontaktelemente dasselbe Stanzteil verwendbar ist, und welches zum anderen den Vorteil bietet, dass Messer- und Gabelkontaktelement jeweils die Funktion des Gegenelementes übernehmen können, so dass ein Gabelkontaktelement gleichzeitig die Funktion eines Messerkontaktelements, ein Messerkontaktelement gleichzeitig die Funktion des Gabelkontaktelements ausüben kann.

Vorzugsweise wird dazu ein Schenkel des U-förmig gebogenen Stanzbiegeelementes geradlinig als Messerkontaktelement, der andere Schenkel des U-förmig gebogenen Stanzbiegeelementes geschwungen zur federnden Aufnahme eines Messerkontaktes ausgebildet. Anders formuliert wird die eine Klaue des Gabelkontaktelements als Messerkontaktelement ausgebildet und so ein Messer-Gabel-Kontaktelement erstellt.

Durch das wechselseitige Ineinandergreifen der Messer der Messer-Gabel-Kontaktelemente in die jeweilige Gabel des gegenseitigen Messer-Gabel-Kontaktelements wird die Kontaktsicherheit der Verbindung zusätzlich erhöht.

Die für eine sichere Kontaktierung erforderlichen Federkräfte wirken vornehmlich innerhalb der Gabelkontakte, so dass benachbarte E/A-Module nicht wie beispielsweise bei seitlichen Druckkontakten durch Kontaktfederkräfte auseinander gedrückt werden.

Die seitlich offene Ausgestaltung der Kontaktelemente ermöglicht ein Öffnen und Schließen des Messer-Gabel-Kontakts in verschiedenen Richtungen der Ebene des flächig ausgebildeten Messerkontaktelements, so dass ein Öffnen und Schließen der Kontakte sowohl in der Achse der Normalen der Hutschiene als auch in der Längsachse der Hutschiene ermöglicht wird.

Zur Unterstützung eines leichten Einführens der Messerkontaktelemente in die Gabelkontaktelemente sind diese seitlich angefast.

Erfindungsgemäß ist damit ferner ein elektrisches Kontaktelement vorgesehen, das dadurch gekennzeichnet ist, dass es als kombiniertes Messer-Gabel-Kontaktelement ausgebildet ist, wobei das kombinierte Messer-Gabel-Kontaktelement sowohl ein wenigstens zwei Klauen umfassenden Gabelkontaktelement als auch ein Messerkontaktelement aufweist und wenigstens eine der

Klauen als Messerkontaktelement verwendbar ist.

Vorzugsweise ist dabei eine Klaue des Gabelkontaktelements geradlinig als Messerkontaktelement ausgebildet.

Weiterhin ist das elektrisches Kontaktelement vorzugsweise durch einen Stanz-Biege-Prozess hergestellt, vorzugsweise aus Federblech, wobei das Gabelkontaktelement derart herstellbar ist, dass zur Ausbildung einer ersten Klaue nach dem Stanz-Prozess kein Biege-Prozess notwendig ist und eine zweite Klaue nach dem Stanz-Prozess durch eine Biegeprozess dadurch ausbildbar ist, dass die zweite Klaue in einer Biegerichtung um einen Biegewinkel von ca. 180° in Achsen parallel zur Längsachse der ersten Klaue gebogen wird.

Dabei wird das elektrisches Kontaktelement vorzugsweise so ausgeführt, dass mit einem baugleichen, nur in umgekehrter Biegerichtung herstellbaren elektrischen Kontaktelement ein Messer-Gabel-Doppelkontakt herstellbar ist, bei der die Messerkontaktelemente und die Gabelkontaktelemente der kombinierten Messer-Gabel-Kontakte wechselseitig ineinander greifen können.

Vorzugsweise können zur Optimierung der Kontaktierung die Klauen der Gabelkontaktelemente mehrfach ausgebildet sein und/oder die Kontaktbereiche der Gabelkontaktelemente und/oder Messerkontaktelemente mit Konturprägungen ausgebildet sein.

Nachfolgend wird die Erfindung unter Bezugnahme auf die anliegende Zeichnung anhand bevorzugter Ausführungsformen näher erläutert.

Es zeigen
- Fig. 1: einen Ausschnitt des E/A-Moduls gemäß einer bevorzugten Ausführungsform der Erfindung
- Fig. 2: einen bevorzugte Ausführungsform des Messer/Gabel-Kontakts bei Schließung in Längsachse
- Fig. 3: einen bevorzugte Ausführungsform des Messer/Gabel-Kontakts bei Schließung quer zur Längsachse
- Fig. 4: eine bevorzugte Ausführungsform des Messer/Gabel-Kontakts in kontaktiertem Zustand.
- Fig. 5: einen bevorzugte Ausführungsform des Messer/Gabel-Doppelkontakts bei Schließung in Längsachse
- Fig. 6: einen bevorzugte Ausführungsform des Messer/Gabel-Doppelkontakts bei Schließung quer zur Längsachse
- Fig. 7: eine bevorzugte Ausführungsform des Messer/Gabel-Doppelkontakts in kontaktiertem Zustand mit ineinandergreifenden Gabelkontakten.
- Fig. 8: eine bevorzugte Ausführungsform des Messer/Gabel-Kontakts mit sequentiell bzw. doppelt ausgeführten Klauen eines Gabelkontakts.

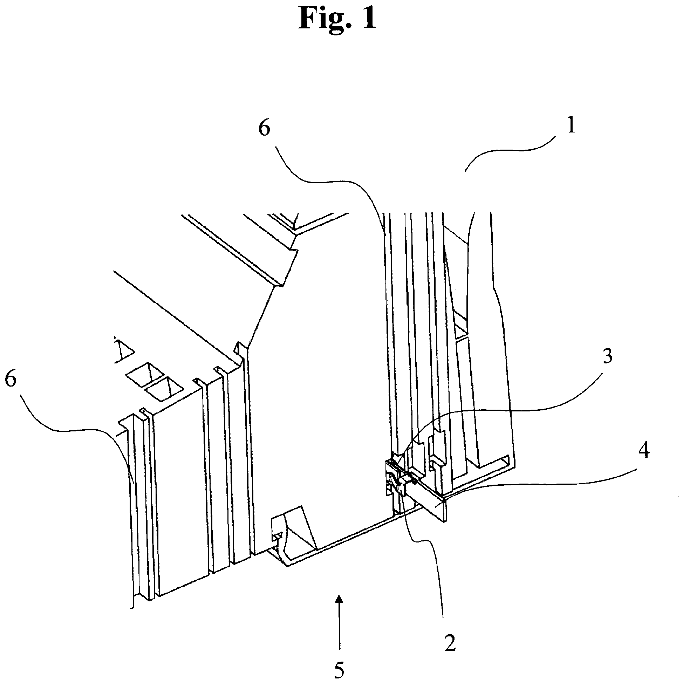

Die Figur 1 zeigt einen Ausschnitt eines E/A-Moguls gemäß einer bevorzugten Ausführungsform der Erfindung. Dargestellt ist die untere rechte Ecke eines erfindungsgemäßen E/A-Modules 1, welches mehrere seitliche Messer/Gabelkontakte 2 aufweist. Dargestellt ist darin ein innerhalb der Einhüllenden des Gehäuses liegendes, also nicht aus der Seitenfläche des E/A-Modules herausragendes Messer-Gabel-Kontaktelement 3.

Auf dieses Messer-Gabel-Kontaktelement 3 ist ein die Wirkungsweise der Erfindung verdeutlichendes Messer-Gabel-Kontaktelement 4 eines Nachbarmoduls aufgeschoben. Der geschlossen dargestellte Messer/Gabel-Kontakt 2 kann in drei Richtungen geöffnet werden: nach unten in Richtung der Unterseite 5 des E/A-Moduls, nach oben in Richtung der Oberseite des Moduls, sowie zur Seite, seitlich aus der Seitenfläche des E/a-Moduls heraus.

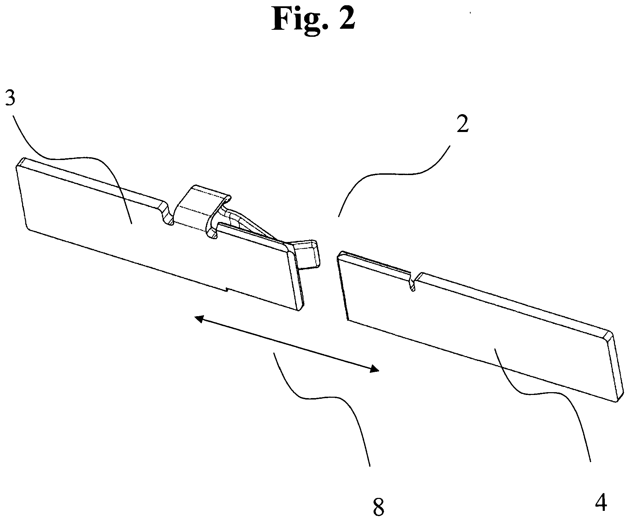

Figur 2 zeigt ein jeweils als Stanzbiegeelement ausgeführtes Gabelkontaktelement 3 und ein Messerkontaktelement 4. Der Messer/Gabel-Kontakt kann in der Achse der Kontaktelemente, welche bevorzugt der Längsachse der Hutschiene 8 entspricht, geöffnet oder geschlossen werden.

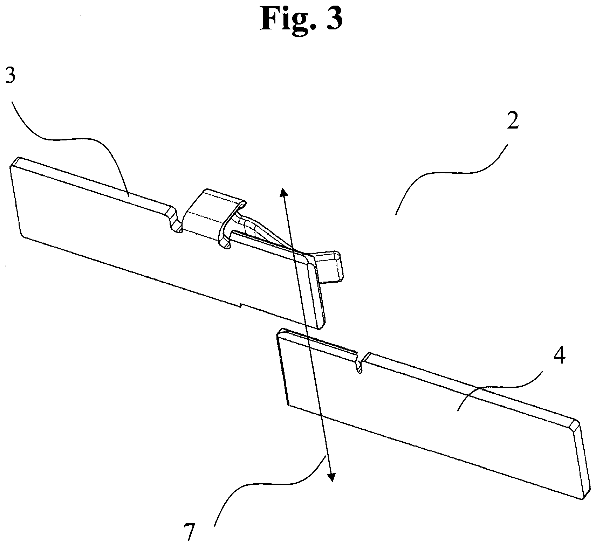

Figur 3 zeigt ebenfalls ein jeweils als Stanzbiegeelement ausgeführtes Gabelkontaktelement 3 und Messerkontaktelement 4. Anders als in Figur 2 wird hier dargestellt, dass aufgrund der seitlich offenen Ausgestaltung des Gabelkontaktes auch ein Öffnen und Schließen in lateraler Richtung, welche bevorzugt der Achse der Normalen der Hutschiene entspricht, erfolgen kann.

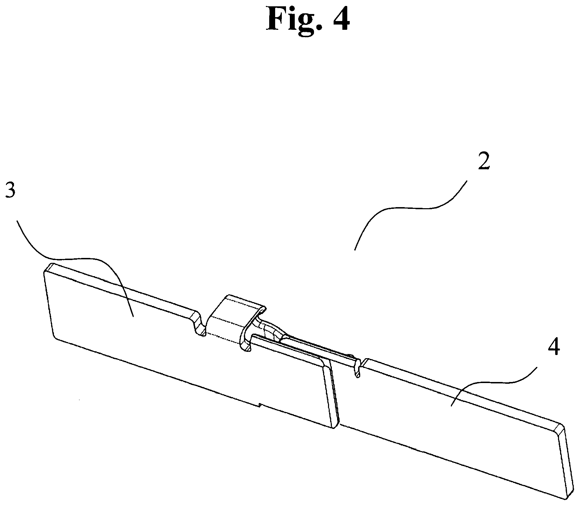

Figur 4 zeigt den Messer/Gabel-Kontakt 2 in geschlossenem bzw. kontaktiertem Zustand. In einmal geschlossenen Zustand treten in Richtung der Längsachse der Kontaktelemente keine Federkräfte auf.

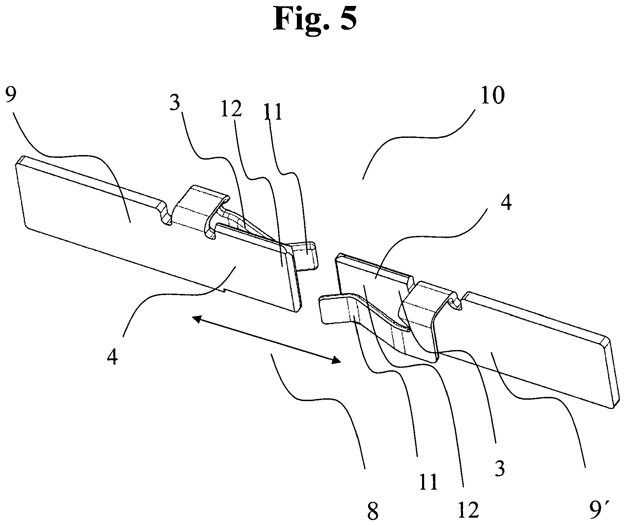

Figur 5 zeigt ein jeweils als Stanzbiegeelement ausgeführtes kombiniertes Messer-Gabel-Kontaktelement 9 und 9'. Dabei weisen beide Elemente vor dem Biegevorgang die gleiche Stanzform auf. Beide Kontaktelemente weisen einen geradlinig ausgebildeten, flächigen Messerkontakt als eine erste Klaue eines Gabelkontakts auf. Die unterschiedliche Biegerichtung der als Blattfeder ausgebildeten zweiten Klaue unterscheidet das erste kombiniertes Messer-Gabel-Kontaktelement 9 von dem zweiten kombinierten Messer-Gabel-Kontaktelement 9'. Der Messer/Gabel-Doppelkontakt 10 kann in der Achse der Kontaktelemente, welche bevorzugt der Längsachse der Hutschiene 8 entspricht, geöffnet oder geschlossen werden.

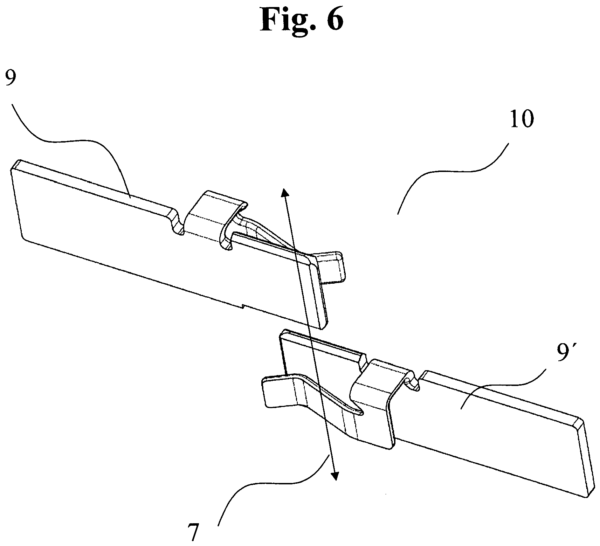

Figur 6 zeigt ebenfalls ein jeweils als Stanzbiegeelement ausgeführtes kombiniertes Messer-Gabel-Kontaktelement 9 und 9'. Anders als in Figur 5 wird hier dargestellt, dass aufgrund der seitlich offenen Ausgestaltung der Gabelkontakte auch ein Öffnen und Schließen in lateraler Richtung, welche bevorzugt der Achse der Normalen der Hutschiene entspricht, erfolgen kann.

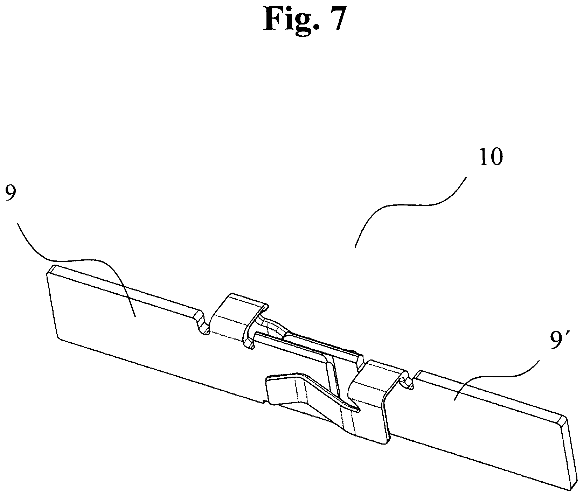

Figur 7 zeigt den Messer/Gabel-Doppelkontakt 10 in geschlossenem Zustand, der das Ineinandergreifen der Gabelkontakte verdeutlicht. In einmal geschlossenen Zustand treten in Richtung der Längsachse der Kontaktelemente keine Federkräfte auf.

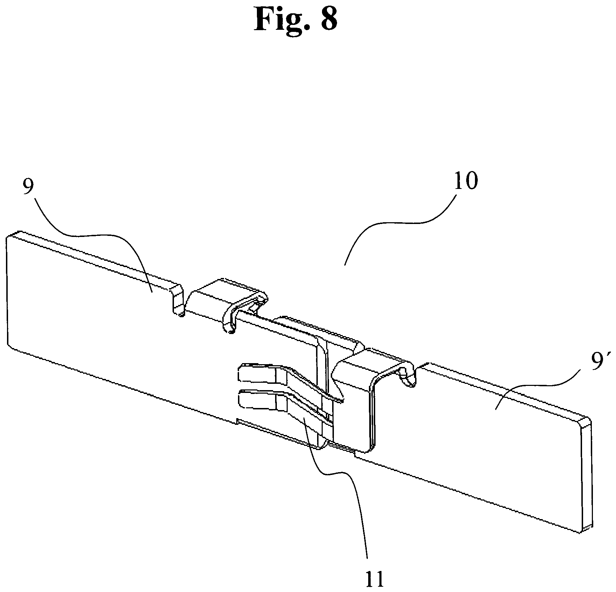

Figur 8 zeigt analog zu Figur 4 den Messer/Gabel-Kontakt 2 in geschlossenem Zustand, wobei die federnd ausgeführte Klaue geteilt dargestellt ist, was zu einer Erhöhung der Anzahl der Kontaktpunkte führt und somit der Verbesserung der Kontaktsicherheit dient.

**Bezugszeichenliste**

| | |
|---|---|
| E/A-Modul | 1 |
| Messer/Gabel-Kontakt | 2 |
| Gabelkontaktelement | 3 |
| Messerkontaktelement | 4 |
| Unterseite | 5 |
| Nut | 6 |
| Achse der Normalen der Hutschiene | 7 |
| Längsachse der Hutschiene | 8 |
| Elektrisches Kontaktelement, Kombiniertes Messer-Gabel-Kontaktelement | 9, 9' |
| Messer/Gabel-Doppelkontakt | 10 |
| Klaue eines Gabelkontaktelements | 11,12 |
| Klaue eines Gabelkontaktelemente und eines Messerkontaktelements | 12 |

## Patentansprüche

1. Elektrisches E/A-Modul (1) zur Montage auf einer Hutschiene, wobei
das E/A-Modul (1) seitlich neben einem anderen E/A-Modul (1) seiner Art auf einer Hutschiene montierbar und mit dem anderen E/A-Modul (1) seitlich zur Erzielung einer Querrangierung über einen Messer/Gabelkontakt (2) kontaktierbar ist,
an den E/A-Modulen (1) Kontaktelemente (9, 9') zur Herstellung des Messer/Gabelkontakts (2) angeordnet sind,
**dadurch gekennzeichnet, dass**
die Kontaktelemente (9, 9') als kombiniertes Messer-Gabel-Kontaktelement (9, 9') ausgeführt sind, wobei
das kombinierte Messer-Gabel-Kontaktelement (9, 9') ein wenigstens zwei Klauen (11, 12) umfassendes Gabelkontaktelement (3) aufweist, wobei wenigstens eine der Klauen (11, 12) geradlinig als Messerkontaktelement (4, 12) ausgebildet ist,
das Messerkontaktelement (4, 12) flächig ausgebildet und seitlich angefast ist,
eine seitlich offene Ausgestaltung der Kontaktelemente (9, 9') ein Öffnen und Schließen des Messer-Gabel-Kontakts (2) in verschiedenen Richtungen der Ebene des Messerkontaktelements (4, 12) ermöglicht, so dass
der Messer/Gabelkontakt (2) durch Bewegung des E/A-Moduls (1) sowohl in der Achse der Normalen (7) der Hutschiene als auch in der Längsachse der Hutschiene (8) zu öffnen bzw. zu schließen ist.

2. Elektrisches E/A-Modul (1) nach Anspruch 1 **dadurch gekennzeichnet, dass** der Messer/Gabelkontakt (2) ein Messerkontaktelement (4, 12) und ein Gabelkontaktelement (3) aufweist und das E/A-Modul (1) wenigstens eines der Kontaktelemente (9, 9') aufweist.

3. Elektrisches E/A-Modul (1) nach einem der vorherigen Ansprüche **dadurch gekennzeichnet, dass** das Messer- und/oder Gabelkontaktelement (4, 12, 3) innerhalb der Grundfläche des E/A-Moduls (1) liegt.

4. Elektrisches E/A-Modul (1) nach einem der vorherigen Ansprüche **dadurch gekennzeichnet, dass** das Messer- und/oder Gabelkontaktelement (4, 12, 3) von der Unterseite (5) des E/A-Moduls (1) her zugänglich angeordnet ist.

5. Elektrisches E/A-Modul (1) nach einem der vorherigen Ansprüche **dadurch gekennzeichnet, dass** das Messer- und/oder Gabelkontaktelement (4, 12, 3) von der Oberseite des E/A-Moduls (1) her zugänglich angeordnet ist.

6. Elektrisches E/A-Modul (1) nach einem der vorherigen Ansprüche **dadurch gekennzeichnet, dass** das Messer- und/oder Gabelkontaktelement (4, 12, 3) von der Oberseite und der Unterseite (5) des E/A-Moduls (1) her zugänglich angeordnet ist.

7. Elektrisches E/A-Modul (1) nach einem der vorherigen Ansprüche **dadurch gekennzeichnet, dass** die Seitenwand des E/A-Moduls (1) eine Ausnehmung aufweist, die ein Eingreifen eines Messer- und/oder Gabelkontaktelements (4, 12, 3) des Nachbarmoduls ermöglicht.

8. Elektrisches E/A-Modul (1) nach einem der vorherigen Ansprüche **dadurch gekennzeichnet, dass** das Messer- und/oder Gabelkontaktelement (4, 12, 3) in der Einhüllenden des Gehäuses des E/A-Moduls (1) liegt und über eine nach oben und nach unten offene Nut (6) zugänglich ist.

9. Elektrisches E/A-Modul (1) nach einem der vorherigen Ansprüche **dadurch gekennzeichnet, dass** das E/A-Modul (1) beidseitig mit Gabelkontaktelementen (3) ausgeführt ist und doppelseitige Messerkontaktelemente (4, 12) in die Gabelkontaktelemente (3) einsteckbar sind.

## Claims

1. An electrical I/O module (1) for mounting on a top hat rail, wherein
the I/O module (1) can be mounted laterally next to another I/O module (1) of its type on a top hat rail and can be contacted with the other I/O module (1) laterally in order to attain a cross-connection via a blade/fork contact (2),
contact elements (9, 9') are arranged on the I/O modules (1) for producing the blade/fork contact (2),
**characterised in that**
the contact elements (9, 9') are embodied as a combined blade-fork contact element (9, 9'), wherein
the combined blade-fork contact element (9, 9') has a fork contact element (3) comprising at least two claws (11, 12), wherein
at least one of the claws (11, 12) is formed in a straight line as a blade contact element (4, 12), the blade contact element (4, 12) is planar and chamfered laterally,
a laterally open embodiment of the contact elements (9, 9') enables the blade/fork contact (2) to be opened and closed in different directions of the plane of the blade contact element (4, 12), such that
the blade/fork contact (2) can be opened and closed by moving the I/O module (1) both in the axis of the normal (7) of the top hat rail and in the longitudinal axis of the top hat rail (8).

2. The electrical I/O module (1) according to claim 1, **characterised in that** the blade/fork contact (2) has a blade contact element (4, 12) and a fork contact element (3) and the I/O module (1) has at least one of the contact elements (9, 9').

3. The electrical I/O module according to any one of the preceding claims, **characterised in that** the blade and/or fork contact element (4, 12, 3) lies within the base area of the I/O module (1).

4. The electrical I/O module (1) according to any one of the preceding claims, **characterised in that** the blade and/or fork contact element (4, 12, 3) is arranged so as to be accessible from the underside (5) of the I/O module (1).

5. The electrical I/O module (1) according to any one of the preceding claims, **characterised in that** the blade and/or fork contact element (4, 12, 3) is arranged so as to be accessible from the upper side of the I/O module (1).

6. The electrical I/O module according to any one of the preceding claims, **characterised in that** the blade and/or fork contact element (4, 12, 3) is arranged so as to be accessible from the upper side and the underside (5) of the I/O module (1).

7. The electrical I/O module (1) according to any one of the preceding claims, **characterised in that** the side wall of the I/O module (1) has a recess that enables engagement of a blade and/or fork contact element (4, 12, 3) of the neighbouring module.

8. The electrical I/O module (1) according to any one of the preceding claims, **characterised in that** the blade and/or fork contact element (4, 12, 3) lies in the envelope of the housing of the I/O module (1) and is accessible via an upwardly and downwardly open groove (6).

9. The electrical I/O module (1) according to any one of the preceding claims, **characterised in that** the I/O module (1) is embodied with fork contact elements (3) on both sides and double-sided blade contact elements (4, 12) can be inserted into the fork contact elements (3).

## Revendications

1. Module d'entrée / sortie, I/O, (1) électrique destiné au montage sur un rail en U, où
le module I/O (1) peut être monté latéralement à côté d'un autre module I/O (1) de son type sur un rail en U et peut être mis en contact latéralement avec l'autre module I/O (1) pour arriver à un assemblage transversal par le biais d'un contact de type lame/fourche (2),
des éléments de contact (9, 9') sont disposés sur les modules I/O (1) pour l'établissement du contact de type lame/fourche (2),
**caractérisé en ce que**
les éléments de contact (9, 9') sont conçus en tant qu'éléments de contact de type lame/fourche (9, 9') combinés, où
l'élément de contact de type lame/fourche (9, 9') combiné présente un élément de contact en fourche (3) comprenant au moins deux dents (11, 12), où
au moins l'une des dents (11, 12) est conçue rectiligne sous forme d'un élément de contact de type lame (4, 12),
l'élément de contact de type lame (4, 12) est conçu plan et est latéralement chanfreiné,
une conception des éléments de contact (9, 9') ouverte latéralement permet une ouverture et une fermeture du contact de type lame/fourche (2) dans différentes directions du plan de l'élément de contact de type lame (4, 12), de sorte que
le contact de type lame/fourche (2) peut être fermé, respectivement ouvert, par un déplacement du module I/O (1) à la fois dans l'axe de la normale (7) du rail en U et dans l'axe longitudinal du rail en U (8).

2. Module I/O électrique (1) selon la revendication 1, **caractérisé en ce que** le contact de type lame/fourche (2) présente un élément de contact de type lame (4, 12) et un élément de contact de type fourche (3) et le module I/O (1) présente au moins un des éléments de contact (9, 9').

3. Module I/O électrique (1) selon l'une des revendications précédentes, **caractérisé en ce que** l'élément de contact de type lame, et/ou l'élément de contact de type fourche (4, 12, 3), se situe à l'intérieur de la surface de base du module I/O (1).

4. Module I/O électrique (1) selon l'une des revendications précédentes, **caractérisé en ce que** l'élément de contact de type lame, et/ou l'élément de contact de type fourche (4, 12, 3), est disposé accessible par la face inférieure (5) du module I/O (1).

5. Module I/O électrique (1) selon l'une des revendications précédentes, **caractérisé en ce que** l'élément de contact de type lame, et/ou l'élément de contact de type fourche (4, 12, 3), est disposé accessible par la face supérieure du module I/O (1).

6. Module I/O électrique (1) selon l'une des revendications précédentes, **caractérisé en ce que** l'élément de contact de type lame, et/ou l'élément de contact de type fourche (4, 12, 3), est disposé accessible par la face supérieure et la face inférieure (5) du module I/O (1).

7. Module I/O électrique (1) selon l'une des revendications précédentes, **caractérisé en ce que** la paroi latérale du module I/O présente une cavité qui permet un engrenage d'un élément de contact de type lame, et/ou d'un élément de contact de type fourche (4, 12, 3), du module voisin.

8. Module I/O électrique (1) selon l'une des revendications précédentes, **caractérisé en ce que** l'élément de contact de type lame, et/ou l'élément de contact de type fourche (4, 12, 3), se situe dans l'enveloppe du boîtier du module I/O (1) et est accessible par le biais d'une rainure (6) ouverte vers le haut et vers le bas.

9. Module I/O électrique (1) selon l'une des revendications précédentes, **caractérisé en ce que** le module I/O (1) est conçu avec des éléments de contact de type fourche (3) des deux côtés et des éléments de contact de type lame (4, 12) peuvent être insérés des deux côtés dans les éléments de contact de type fourche (3).
